(19) Europäisches Patentamt
European Patent Office
Office européen des brevets

(11) EP 1 783 820 A1

(12) EUROPEAN PATENT APPLICATION
published in accordance with Art. 158(3) EPC

(43) Date of publication:
09.05.2007 Bulletin 2007/19

(21) Application number: 04748190.8

(22) Date of filing: 02.08.2004

(51) Int Cl.:
*H01L 21/02* (2006.01) *H01L 21/68* (2006.01)
*C09J 201/00* (2006.01) *C09J 5/00* (2006.01)
*C09J 7/02* (2006.01)

(86) International application number:
PCT/JP2004/011057

(87) International publication number:
WO 2006/013616 (09.02.2006 Gazette 2006/06)

(84) Designated Contracting States:
AT BE BG CH CY CZ DE DK EE ES FI FR GB GR HU IE IT LI LU MC NL PL PT RO SE SI SK TR

(71) Applicant: SEKISUI CHEMICAL CO., LTD.
Osaka-shi,
Osaka 530-8565 (JP)

(72) Inventors:
- HATAI, Munehiro, Sekisui Chemical Co., Ltd. Mishima-gun, Osaka 6188589 (JP)
- HAYASHI, Satoshi, Sekisui Chemical Co., Ltd. Mishima-gun, Osaka 6188589 (JP)
- FUKUOKA, Masateru, Sekisui Chemical Co., Ltd. Mishima-gun, Osaka 6188589 (JP)
- DANJO, Shigeru, Sekisui Chemical Co., Ltd. Mishima-gun, Osaka 6188589 (JP)
- OYAMA, Yasuhiko, Sekisui Chemical Co., Ltd. Tokyo 1058450 (JP)
- SHIMOMURA, Kazuhiro, Sekisui Chemical Co., Ltd. Hasuda-shi, Saitama 3490198 (JP)
- SUGITA, Daihei, Sekisui Chemical Co., Ltd. Hasuda-shi, Saitama 3490198 (JP)
- KITAJIMA, Yoshikazu, Sekisui Chemical Co., Ltd. Hasuda-shi, Saitama 3490198 (JP)

(74) Representative: Hart Davis, Jason
Cabinet Beau de Loménie,
158, rue de l'Université
75340 Paris Cedex 07 (FR)

# (54) PROCESS FOR PRODUCING IC CHIP

(57) It is an object of the invention to provide a method for producing an IC chip capable of producing an IC chip with a thickness as extremely thin as 50 μm or thinner, for example, about 25 to 30 μm at a high productivity.

The invention is a method for producing an IC chip, which comprises; at least a step 1 of fixing a wafer in a support plate by sticking the wafer to the gas generating agent-containing face of a pressure sensitive adhesive double-faced tape having a pressure sensitive adhesive layer containing a gas generating agent for generating a gas by light radiation in at least one face; a step 2 of grinding the wafer in a state of being fixed in the support plate through the pressure sensitive adhesive double-faced tape; a step 3 of radiating light to the pressure sensitive adhesive double-faced tape; and a step 4 of separating the pressure sensitive adhesive double-faced tape from the wafer, a gas releasing speed from the pressure sensitive adhesive double-faced tape being 5 $L/cm^2 \cdot min$ or higher in the step 3.

EP 1 783 820 A1

[Fig. 1]

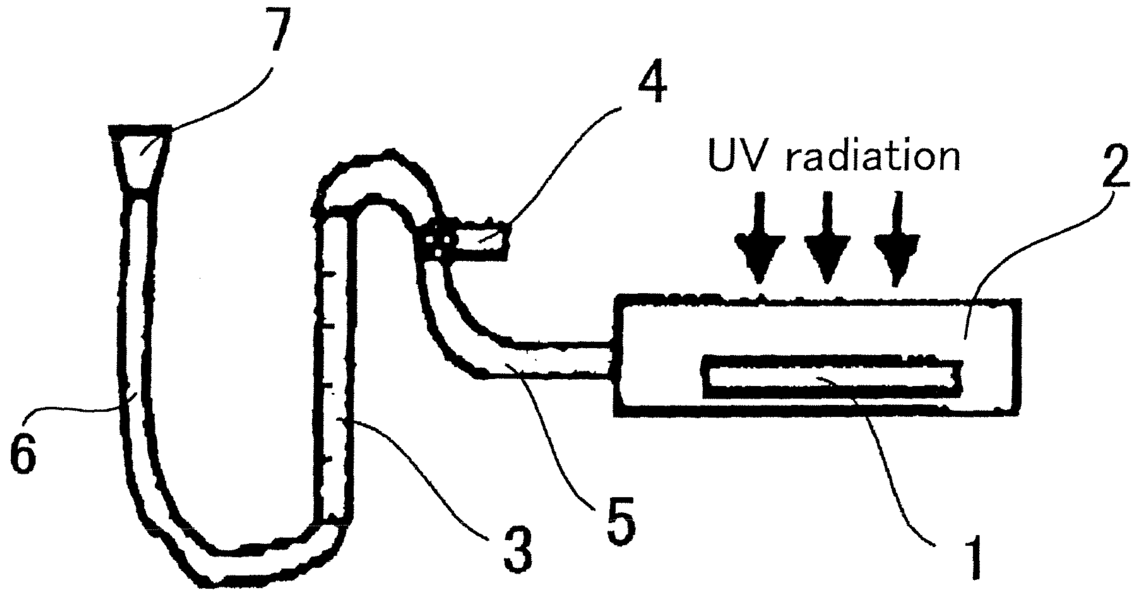

## Description

TECHNICAL FIELD

The invention relates to a method for producing an IC chip capable of producing an IC chip with a thickness as extremely thin as 50 μm or thinner, for example, about 25 to 30 μm at a high productivity.

BACKGROUND ART

A semiconductor integrated circuit (IC chip) is produced generally by slicing a rod-like semiconductor single crystal with a high purity for obtaining a wafer, forming a prescribed circuit pattern on the wafer surface by using photoresist, successively grinding the rear face of the wafer by a grinder for making the thickness of the wafer thin to about 100 to 600 μm, and finally dicing the wafer into chips.

In the method for producing an IC chip in the above-mentioned manner, since the wafer tends to be broken especially at the time of grinding and dicing the wafer, a support plate is stuck to the wafer surface with a pressure sensitive adhesive double-faced sheet at the time of grinding or a dicing tape is stuck to the wafer rear face side at the time of dicing to prevent the damage of the wafer. However, steps of sticking and releasing the pressure sensitive adhesive double-faced sheet or the dicing tape are complicated and they are problematic in terms of productivity of the IC chip.

Recently, as uses of IC chips have become wide, it has been required to develop an IC chip with a thickness as thin as about 50 μm and usable for IC cards or in form of layers. However a semiconductor wafer with such a thin thickness is inferior in the handling property since it is easy to warp considerably and be cracked by impacts as compared with a conventional wafer with a thickness of about 100 to 600 μm and the semiconductor wafer may be broken in the processing by the same method which has been applied for processing a semiconductor wafer with a conventional thickness. Therefore, it becomes an important issue to improve the handling easiness of the wafer in the process of producing an IC chip from a semiconductor wafer with a thickness as thin as about 50 μm.

To deal with the issue, Patent Document 1 discloses a method for producing an IC chip involving fixing a wafer on a support plate through a pressure sensitive adhesive double-faced tape having a pressure sensitive adhesive layer containing a gas generating agent for generating a gas by stimulation and a crosslinking component for crosslinking by stimulation in one face or both faces and then carrying out a step of grinding the wafer in that state. Because of the fixation in the support plate, even if the wafer is ground to a thickness as thin s about 50 μm, the wafer is not broken. Further, in the method for producing an IC chip, after the stimulation for crosslinking the crosslinking component is applied to the pressure sensitive adhesive double-faced tape, stimulation for gas generation is applied to easily separate the pressure sensitive adhesive double-faced tape from the wafer without damaging the wafer. It is because the gas is generated from the gas generating agent in the pressure sensitive adhesive layer whose elastic modulus is increased by crosslinking the crosslinking component and the generated gas is released from the pressure sensitive adhesive to cause at least partial separation of the adhesion face of the wafer and the pressure sensitive adhesive double-faced tape and thus lower adhesive strength.

According to the method disclosed in Patent Document 1, a thin IC chip with a thickness of about 50 μm can be efficiently produced.

However, in recent years, an IC chip with a thickness as extremely thin as 50 μm or thinner, for example, about 25 to 30 μm, has been required. To produce such an extremely thin IC chip by the method disclosed in Patent Document 1, the wafer ground to have about 25 to 30 μm thickness has to be separated and recovered from the pressure sensitive adhesive double-faced tape without damaging the ground wafer. However, in the case of the wafer with the thickness as extremely thin as 25 to 30 μm, it is difficult to separate the wafer without damaging the wafer even if the adhesive strength is simply decreased and it is impossible to separate the wafer from the pressure sensitive adhesive double-faced tape without damaging it by only lowering the adhesive strength unless the wafer is completely separated from the pressure sensitive adhesive double-faced tape by only stimulating the tape and the separated wafer is as if being put in a state that the wafer is floating on the pressure sensitive adhesive double-faced tape (hereinafter, such existence state may be sometimes referred to as self separation). Although it has been confirmed highly possible to produce the self separation state depending on the conditions, actually such conditions to always reliably produce the self separation state have not been made clear yet and it has been an issue to overcome in terms of the improvement of productivity of the IC chip with a thickness of about 25 to 30 μm.

Patent Document 1: Japanese Kokai Publication 2003-231872

## DISCLOSURE OF THE INVENTION

## PROBLEMS WHICH THE INVENTION IS TO SOLVE

In view of the above-mentioned state of the art, the invention aims to provide a method for producing an IC chip capable of producing an IC chip with a thickness as extremely thin as 50 μm or thinner, for example, about 25 to 30 μm at a high productivity.

## MEANS FOR SOLVING THE OBJECT

The invention provides a method for producing an IC chip, which comprises; at least a step 1 of fixing a wafer in a support plate by sticking the wafer to the gas generating agent-containing face of a pressure sensitive adhesive double-faced tape having a pressure sensitive adhesive layer containing a gas generating agent for generating a gas by light radiation in at least one face; a step 2 of grinding the wafer in a state of being fixed in the support plate through the pressure sensitive adhesive double-faced tape; a step 3 of radiating light to the pressure sensitive adhesive double-faced tape; and a step 4 of separating the pressure sensitive adhesive double-faced tape from the wafer, a gas releasing speed from the pressure sensitive adhesive double-faced tape being 5 $L/cm^2 \cdot min$ or higher in the step 3.
Hereinafter the invention will be described below in detail.

The inventors of the invention have made intensive investigations and have consequently found that in the case where a wafer is fixed in a support plate through a pressure sensitive adhesive double-faced tape having a pressure sensitive adhesive layer containing a gas generating agent for generating a gas by light radiation, the gas release speed from the pressure sensitive adhesive double-faced tape is very important to always reliably cause self separation at the time of separation of the wafer. From the results of the further intensive investigations, inventors have found that the gas release speed from the pressure sensitive adhesive double-faced tape can be controlled by adjusting various conditions such as the type and content of the gas generating agent, the gel fraction and elastic modulus of the pressure sensitive adhesive layer, and the dose of ultraviolet rays at the time of separation; that the self separation can be caused always reliably by keeping the gas release speed constant in relation to these conditions; and that accordingly it is made possible to produce an IC chip with a thickness as extremely thin as 50 μm or thinner, for example, about 25 to 30 μm, at a high productivity, and consequently, these findings have now led to completion of the invention.

The method for producing an IC chip of the invention comprises a step 1 of fixing a wafer in a support plate by sticking the wafer to the gas generating agent-containing face of a pressure sensitive adhesive double-faced tape having a pressure sensitive adhesive layer containing a gas generating agent for generating a gas by light radiation in at least one face.
Fixation of the wafer in the support plate improves the handling property of the wafer and prevents damage of the wafer even if the thickness of the wafer is as extremely thin as 50 μm or thinner and thus makes it possible to process the wafer well into IC chips.
At that time, the wafer is obtained by slicing a silicon single crystal, a gallium arsenic single crystal, or the like for obtaining a semiconductor wafer and forming a prescribed circuit pattern on the wafer surface and has a thickness of about 500 μm to 1 mm. At the time of fixing the wafer in the support plate, the face of the wafer where the circuit is formed and the pressure sensitive adhesive double-faced tape are stuck to each other.

The above-mentioned support plate is not particularly limited, however it is preferably transparent for allowing light to transmit or pass through. Examples of the support plate are plates made of resins such as acrylics, olefins, polycarbonates, vinyl chlorides, ABS, PET, nylons, urethanes, and polyimides.

The lower limit of the thickness of the support plate is preferably 500 μm and the upper limit is preferably 3 mm and the lower limit is more preferably 1 mm and the upper limit is more preferably 2 mm. The unevenness of the thickness of the above-mentioned support plate is preferably 1% or lower.

The above-mentioned pressure sensitive adhesive double-faced tape contains a pressure sensitive adhesive layer containing a gas generating agent for generating a gas by light radiation on at least one face. Because of the addition in the gas generating agent, a gas is generated from the gas generating agent when light is radiated to the pressure sensitive adhesive double-faced tape and the adhesion face is separated to actualize the self separation.
The above-mentioned pressure sensitive adhesive double-faced tape may be a support tape with the pressure sensitive adhesive layers formed in both faces of a substrate or a non-support tape having no substrate.
The above-mentioned substrate is not particularly limited and those which allow light to be transmitted or pass through are preferably used, and sheets, sheets having mesh-like structure, and sheets having holes, which are made of transparent resins such as acrylics, olefins, polycarbonates, vinyl chloride, ABS, polyethylene terephthalate (PET), nylons, urethanes, and polyimides, can be exemplified.

Light for generating the gas from the above-mentioned gas generating agent may be, for example, ultraviolet rays and visible light rays. The pressure sensitive adhesive layer containing the above-mentioned gas generating agent

is preferable to allow light to be transmitted or pass through.
The gas generating agent for generating the gas by light radiation is not particularly limited and for example, azo compounds, azide compounds, nitroso compounds, hydrazine derivatives, and bicarbonates can be exemplified.

Examples of the above-mentioned azo compounds my be 2,2'-azobis(N-cyclohexyl-2-methylpropionamide), 2,2'-azobis[N-(2-methylpropyl)-2-methylpropionamide], 2,2'-azobis(N-butyl-2-methylpropionamide), 2,2'-azobis[N-(2-methylethyl)-2-methylpropionamide], 2,2'-azobis(N-hexyl-2-methylpropionamide), 2,2'-azobis(N-propyl-2-methylpropionamide), 2,2'-azobis(N-ethyl-2-methylpropionamide), 2,2'-azobis{2-methyl-N-[1,1-bis(hydroxymethyl)-2-hydroxyethyl]propionamide}, 2,2'-azobis{2-methyl-N-[2-(1-hydroxybutyl)]propionamide}, 2,2'-azobis[2-methyl-N-(2-hydroxyethyl)propionamide], 2,2'-azobis[N-(2-propenyl)-2-methylpropionamide], 2,2'-azobis[2-(5-methyl-2-imidazolin-2-yl)propane] dihydrochloride, 2,2'-azobis[2-(2-imidazolin-2-yl)propane] dihydrochloride, 2,2'-azobis[2-(2-imidazolin-2-yl)propane] disulfate dihydrate, 2,2'-azobis[2-(3,4,5,6-tetrahydropyrimidin-2-yl)propane] dihydrochloride, 2,2'-azobis{2-[1-(2-hydroxyethyl)-2-imidazolin-2-yl]propane} dihydrochloride, 2,2'-azobis[2-(2-imidazolin-2-yl)propane], 2,2'-azobis(2-methylpropioneamidine) hydrochloride, 2,2'-azobis(2-aminopropane) dihydrochloride, 2,2'-azobis[N-(2-carboxyacyl)-2-methylpropioneamidine], 2,2'-azobis{2-[N-(2-carboxyethyl)amidine]propane}, 2,2'-azobis(2-methylpropionamidoxime), dimethyl-2,2'-azobis(2-methylpropionate), dimethyl-2,2'-azobisisobutylate, 4,4'-azobis(4-cyanocarbonic acid), 4,4'-azobis(4-cyanopentanolc acid), and 2,2'-azobis(2,4,4-trimethylpentane).
These azo compounds generate nitrogen gas by radiating light having a wavelength of mainly 350 to 450 nm.

The above-mentioned azo compounds are preferably to have a 10-hour half-life temperature of 80˚C or higher. If the 10-hour half-life temperature is lower than 80˚C, at the time of forming a pressure sensitive adhesive layer by casting on a substrate and drying the layer, foams may be generated, or decomposition reaction may be caused as time passes and the decomposition residues may bleed out, or a gas is possibly generated as time passes to result in floating of the stuck object in the interface. If the 10-hour half-life temperature is 80˚C or higher, since the heat resistance is excellent, usage and stable storage at a high temperature are made possible.

Examples of azo compounds having 10-hour half-life temperature of 80˚C or higher are azoamide compounds defined by the following general formula (1). The azoamide compounds represented by the following general formula (1) are excellent in heat resistance and also excellent in the solubility in a polymer having pressure sensitive adhesiveness such as acrylic acid alkyl ester polymers, which will be described later, and do not exist in the pressure sensitive adhesive layer in form of particles.

[Chem. 1]

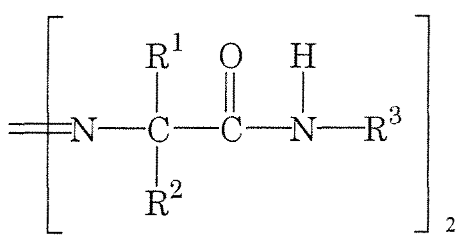

(1)

in the formula (1), $R^1$ and $R^2$ independently represent a lower alkyl group; $R^3$ represents a saturated alkyl group having 2 or more carbon atoms; and $R^1$ and $R^2$ may be same or different.

Examples of the azoamide compounds represented by the general formula (1) include 2,2'-azobis(N-cyclohexyl-2-methylpropionamide), 2,2'-azobis[N-(2-methylpropyl)-2-methylpropionamide], 2,2'-azobis(N-butyl-2-methylpropionamide), 2,2'-azobis[N-(2-methylethyl)-2-methylpropionamide], 2,2'-azobis(N-hexyl-2-methylpropionamide), 2,2'-azobis(N-propyl-2-methylpropionamide), 2,2'-azobis(N-ethyl-2-methylpropionamide), 2,2'-azobis{2-methyl-N-[1,1-bis(hydroxymethyl)-2-hydroxyethyl]propionamide}, 2,2'-azobis{2-methyl-N-[2-(1-hydroxybutyl)]propionamide}, 2,2'-azobis[2-methyl-N-(2-hydroxyethyl)propionamide], and 2,2'-azobis[N-(2-propenyl)-2-methylpropionamide]. Among them are preferably employed 2,2'-azobis(N-butyl-2-methylpropionamide) and 2,2'-azobis[N-(2-propenyl)-2-methylpropionamide] since they are particularly excellent in the solubility in a solvent.

The above-mentioned azide compounds are not particularly limited and examples may include 3-azidomethyl-3-methyloxetane, terephthalazide, p-tert-butylbenzazide; and polymers having azido group such as glycidylazido polymers obtained by ring-opening polymerization of 3-azidomethyl-3-methyloxetane. These azide compounds generate nitrogen gas by radiating light having a wavelength of mainly 350 to 450 nm.

The above-mentioned nitroso compounds may include, for example, N,N'-dinitrosopentamethylenetetramine (DPT). These nitroso compounds generate nitrogen gas by radiating light.

The above-mentioned hydrazine derivatives are not particularly limited and examples may include 4,4'-oxybis(benzenesulfonylhydrazide) (OBSH) and hydrazodicarbonamide (HDCA). These hydrazine derivatives generate nitrogen gas and ammonia gas by radiating light.

The above-mentioned bicarbonates are not particularly limited and, for example, sodium hydrogen carbonate can be exemplified. These bicarbonates generate carbon dioxide gas by radiating light.

The above-mentioned azide compounds among these gas generating agents are decomposed easily and generate nitrogen gas by impact application and therefore they have a problem of handling difficulty. Further, once they start decomposing, the above-mentioned azide compounds cause chain reaction and explosively generate nitrogen gas and cannot be controlled, so that they may cause a problem that a stuck object is damaged by the explosively generated nitrogen gas. Because of these problems, the use amount of the above-mentioned azido compounds is limited, however it may be also possible that no sufficient effect can be caused if the use amount is limited.

On the other hand, unlike the azide compounds, the above-mentioned azo compounds do not generate a gas by impacts and therefore are extremely easy to handle. Further, since they do not generate a gas explosively by chain reaction and therefore they do not damage a stuck object and if ultraviolet ray radiation is stopped, the gas generation can be stopped as well and accordingly, they are advantageous in terms of the controllability of the adhesiveness in accordance with the uses. Consequently, it is more preferable to use an azo compound as the above gas generating agent.

The above-mentioned gas generating agent is preferable to be dissolved in the pressure sensitive adhesive layer. Dissolution of the above-mentioned gas generating agent in the pressure sensitive adhesive layer efficiently releases the gas generated from the gas generating agent at the time of light radiation outside of the pressure sensitive adhesive layer. If the gas generating agent exists in form of particles in the pressure sensitive adhesive layer, the locally generated gas foams the pressure sensitive adhesive layer and it sometimes makes the gas hard to be released outside of the pressure sensitive adhesive layer. Further, when light is radiated as the stimulation for generating a gas, the light is scattered on the interfaces of the particles to lower the gas generation efficiency or worsen the surface smoothness of the pressure sensitive adhesive layer in some cases. In this connection, dissolution of the above-mentioned gas generating agent in the pressure sensitive adhesive layer can be confirmed based on the fact that no particle of the gas generating agent can be observed in the case where the pressure sensitive adhesive layer is observed by an electron microscope.

To dissolve the above-mentioned gas generating agent in the pressure sensitive adhesive layer, a gas generating agent which is to be dissolved in the pressure sensitive adhesive composing the pressure sensitive adhesive layer may be selected properly. If a gas generating agent which is not dissolved in the pressure sensitive adhesive is to be selected, it is preferable to micro-disperse the gas generating agent in the pressure sensitive adhesive layer as much as possible by using a dispersing apparatus or using a dispersant in combination. To micro-disperse the gas generating agent in the pressure sensitive adhesive layer, the gas generating agent is preferable to be in form of fine particles and further these fine particles are preferable to be further finer particles formed based on necessity by using a dispersing apparatus, a kneading apparatus or the like. That is, it is further preferable to disperse the gas generating agent to such an extent that the gas generating agent cannot be seen when the pressure sensitive adhesive layer is observed by an electron microscope.

In the step 3, which will be described later, to control the gas releasing speed from the above-mentioned pressure sensitive adhesive double-faced tape at 5 $\mu L/cm^2 \cdot$ min or higher, it is very important to select the gas generating agent and adjust the content of the gas generating agent contained in the pressure sensitive adhesive layer. The content of the gas generating agent may be properly selected in accordance with the type of the gas generating agent and, for example, in the case where an azo compound is to be used as the gas generating agent, it is preferably 5 to 50 parts by weight to 100 parts by weight of the pressure sensitive adhesive. If it is lower than 5 parts by weight, no sufficient gas releasing speed can be obtained and self separation cannot be sometimes accomplished and if it exceeds 50 parts by weight, the solubility is worsened and a trouble such as bleeding may occur in some cases. It is more preferably 15 to 30 parts by weight.

The pressure sensitive adhesive composing the face containing the gas generating agent is preferably a stimulation-curing pressure sensitive adhesive whose pressure sensitive adhesive strength is decreased by stimulation. Since the stimulation-curing pressure sensitive adhesive whose pressure sensitive adhesive strength is decreased by stimulation causes even and quick polymerization and crosslinking of the entire pressure sensitive adhesive layer and units the pressure sensitive adhesive layer by applying light radiation or other stimulation of heat or the like, the elastic modulus is remarkably increased by polymerization curing and the pressure sensitive adhesive strength is considerably decreased. Further, if a gas is generated from the gas generating agent in the hard cured substance, almost all of the generated gas is released outside to result in improvement of the gas releasing speed from the above-mentioned pressure sensitive adhesive double-faced tape and the self separation can be achieved.

The stimulation for decreasing the pressure sensitive adhesiveness of the stimulation-curing pressure sensitive adhesive may be light radiation or other stimulation of heat, ultrasonic wave or the like.

Examples of the stimulation-curing pressure sensitive adhesive include photocurable pressure sensitive adhesives containing an acrylic acid alkyl ester type and/or methacrylic acid alkyl ester type polymerizable polymer having

a radical polymerizable unsaturated bond in a molecule and a radical polymerizable polyfunctional oligomer or polyfunctional monomer as main components and if necessary a photopolymerization initiator and a thermosetting pressure sensitive adhesives containing an acrylic acid alkyl ester type and/or methacrylic acid alkyl ester type polymerizable polymer having a radical polymerizable unsaturated bond in a molecule and a radical polymerizable polyfunctional oligomer or polyfunctional monomer as main components and a heat polymerization initiator.

The above-mentioned polymerizable polymer can be obtained by previously synthesizing (meth)acrylic polymer having a functional group in the molecule (hereinafter, referred to as a functional group-containing (meth)acrylic polymer) and causing reaction of the synthesized polymer with a compound having a radical polymerizable unsaturated bond and a functional group reactive on the above-mentioned functional group in the molecule (hereinafter, referred to as a functional group-containing unsaturated compound).

Similarly to the case of common (meth)acrylic polymers, the functional group-containing (meth)acrylic polymer, as a polymer having pressure sensitive adhesiveness at a normal temperature, can be obtained by copolymerization of an acrylic acid alkyl ester and/or methacrylic acid alkyl ester whose alkyl group contains carbon atoms generally in number of 2 to 18 as a main monomer with a functional group-containing monomer and if necessary other monomers for reforming copolymerizable with these monomers by a conventional method. The weight average molecular weight of the above-mentioned functional group-containing (meth)acrylic polymer is generally about 200,000 to 2,000,000.

Examples of the functional group-containing monomer may be carboxyl group-containing monomers such as acrylic acid and methacrylic acid; hydroxyl group-containing monomers such as hydroxyethyl acrylate and hydroxyethyl methacrylate; epoxy group-containing monomers such as glycidyl acrylate and glycidyl methacrylate; isocyanato group-containing monomers such as isocyanatoethyl acrylate and isocyanatoethyl methacrylate; and amino group-containing monomers such as aminoethyl acrylate and aminoethyl methacrylate.

Examples of the above-mentioned copolymerizable other monomers for reforming may be various kinds of monomers to be used for common (meth)acrylic polymers such as vinyl acetate, acrylonitrile, styrene.

As the functional group-containing unsaturated compound to be reacted with the above-mentioned functional group-containing (meth)acrylic polymer can be used monomers similar to the above-mentioned functional group-containing monomers in accordance with the functional groups of the functional group-containing (meth)acrylic polymer. Examples may be epoxy group-containing monomers and isocyanato group-containing monomers in the case where the functional group of the above-mentioned functional group-containing (meth)acrylic polymer is a carboxyl group; isocyanato group-containing monomers in the case where the functional group is a hydroxyl group; carboxyl group-containing monomers and amido group-containing monomers such as acrylamide in the case where the functional group is an epoxy group; and epoxy group-containing monomers in the case where the functional group is an amino group.

The number of the functional group per one molecule of the above-mentioned polyfunctional oligomer or polyfunctional monomer is preferably 5 or higher. If it is less than 5, the curing (crosslinking) of the pressure sensitive adhesive becomes insufficient and decrease of the adhesive strength may become insufficient. The above-mentioned polyfunctional oligomer or polyfunctional monomer is preferably those having a molecular weight of 10,000 or lower and more preferably those having a molecular weight of 5,000 or lower so as to efficiently form a three-dimensional net in the pressure sensitive adhesive layer by heating or light radiation and having the number of the radical polymerizable unsaturated bonds in the molecule in a range from 2 to 20.

Examples of the polyfunctional oligomer or polyfunctional monomer are trimethylolpropane triacrylate, tetramethylolmethane tetraacrylate, pentaerythritol triacrylate, pentaerythritol tetraacrylate, dipentaerythritol monohydroxypentaacrylate, dipentaerythritol hexaacrylate, and their methacrylates. Examples may additionally include 1,4-butylene glycol diacrylate, 1,6-hexanediol diacrylate, polyethylene glycol diacrylate, commercialized oligomer ester acrylate, epoxy acrylate, urethane acrylate, and their methacrylates. These polyfunctional oligomers or polyfunctional monomers may be used alone or two or more of them may be used in combination.

In the case where the above-mentioned photocurable pressure sensitive adhesive or thermosetting pressure sensitive adhesive is used as the pressure sensitive adhesive composing the face containing the above-mentioned gas generating agent, in the step 3, which will be described later, to adjust the gas releasing speed from the pressure sensitive adhesive double-faced tape at 5 $\mu L/cm^{2} \cdot$ min or higher, the addition amount of the polyfunctional oligomer or polyfunctional monomer is important. That is, to actualize the prescribed gas generation speed or higher in the step 3 to be described later, it is preferable that the curing of the pressure sensitive adhesive layer is sufficiently promoted to have a prescribed gel fraction or higher or a prescribed elastic modulus or higher at the time of gas generation.

The content of the polyfunctional oligomer or polyfunctional monomer in the above-mentioned pressure sensitive adhesive is preferably 10 to 100 parts by weight to 100 parts by weight of the acrylic acid alkyl ester type and/or methacrylic acid alkyl ester type polymerizable polymer. If it is lower than 10 parts by weight, the pressure sensitive adhesive layer may not be sufficiently cured at the time of gas generation and therefore, no sufficient gas releasing speed cannot be obtained and no self separation can be achieved in some cases and on the other hand, if it exceeds 100 parts by weight, the prepared pressure sensitive adhesive layer is not provided with sufficient cohesive strength or the polyfunctional oligomer or polyfunctional monomer may bleed out of the pressure sensitive adhesive layer in some cases. It is more

preferably 20 to 40 parts by weight.

The above-mentioned photopolymerization initiator may include, for example, those which are activated by radiating light with a wavelength of 250 to 800 nm, and examples of the photopolymerization initiator may include photo radical polymerization initiators, e.g., acetophenone derivative compounds such as methoxyacetophenone; benzoine ether type compounds such as benzoine propyl ether and benzoine isobutyl ether; ketal derivative compounds such as benzyl dimethyl ketal and acetophenone diethyl ketal; phosphine oxide derivative compounds; bis($\eta^5$-cyclopentadienyl) titanocene derivative compounds; benzophenone, Michler's ketone, chlorothioxanthone, dodecylthioxanthone, dimethylthioxanthone, diethylthioxanthone, $\alpha$-hydroxycyclohexyl phenyl ketone, and 2-hydroxymethylphenylpropane. These photopolymerization initiators may be used alone or two or more of them may be used in combination.

The above-mentioned heat polymerization initiator may include those which generate active radicals for starting the polymerization curing by heat decomposition and practical examples are dicumyl peroxide, di-tert-butyl peroxide, tert-butyl peroxybenzoate, tert-butyl hydroperoxide, benzoyl peroxide, cumene hydroperoxide, diisopropylbenzene hydroperoxide, p-menthane hydroperoxide, and di-tert-butyl peroxide. Since having a high heat decomposition temperature, cumene hydroperoxide, p-menthane hydroperoxide, and di-tert-butyl peroxide are preferable among them. Among these heat polymerization initiators, commercialized products are not particularly limited and Perbutyl D, Perbutyl H, Perbutyl P, Permethane H (all manufactured by NOF Corporation) are preferable. These heat polymerization initiators may be used alone or two or more of them may be used in combination.

Other than the above-mentioned components, the above-mentioned post-curable pressure sensitive adhesive may be properly mixed with various kinds of polyfunctional compounds, which are commonly added to a pressure sensitive adhesive, such as isocyanate compounds, melamine compounds, and epoxy compounds based on the necessity to adjust the cohesive strength as a pressure sensitive adhesive. Further, conventionally known additives such as a plasticizer, a resin, a surfactant, wax, and a fine particle filler may be added.

In the step 1, the gas generating agent-containing face of the above-mentioned pressure sensitive adhesive double-faced tape and the wafer are stuck to each other. At that time, to stick them with a better plane property, it is preferable to carry out sticking in vacuum state by using a vacuum laminator or the like.

Since the wafer is fixed in a support plate and thus reinforced in the step 1, at the time of transporting or processing even a very thin wafer with 50 $\mu$m or thinner thickness, no cracking or fracture occurs and on completion of a series of the steps of producing an IC chip, the pressure sensitive adhesive double-faced tape can be separated easily from the IC chip by radiating light.

The method for producing an IC chip of the invention comprises the step 2 of grinding the wafer in a state of being fixed in the support plate through the pressure sensitive adhesive double-faced tape. Fixation in the support plate can prevent breakage of the wafer in the grinding step and makes it possible to carry out grinding of the wafer smoothly.

The method for producing an IC chip of the invention comprises the step 3 of radiating light to the above-mentioned pressure sensitive adhesive double-faced tape. Radiation of light generates a gas from the gas generating agent in the pressure sensitive adhesive layer in the face of the pressure sensitive adhesive double-faced tape contacting with the wafer and lowers the pressure sensitive adhesive strength between the pressure sensitive adhesive double-faced tape and the wafer and thus actualizes the self separation.

A method of radiating light is not particularly limited and in the case where a transparent support plate is used, light may be radiated to the surface of the pressure sensitive adhesive double-faced tape from the support plate side. Further, a light radiation apparatus is not particularly limited, however since it is difficult for a scanning type radiation apparatus to carry out even radiation, this type radiation apparatus may cause partial separation and accordingly crack the wafer and therefore, it is preferable to employ a radiation apparatus which can radiate light evenly to the radiation face.

The dose of light at that time also considerably affects the gas releasing speed from the above-mentioned pressure sensitive adhesive double-faced tape. In the invention, the dose of the light radiated to the above-mentioned pressure sensitive adhesive double-faced tape may be properly determined in accordance with the type and the content of the gas generating agent and the thickness of the support plate, and light radiation is preferable to be carried out at light intensity of 20 to 1000 mW/cm$^2$ in integrated light volume of 2000 to 6000 mJ/cm$^2$.

If the light intensity is lower than 20 mW/cm$^2$, a sufficient gas releasing speed cannot be obtained and the self separation cannot be accomplished and if it exceeds 1000 mW/cm$^2$, the pressure of the generated gas is increased so high as to break the IC chip in some cases.

If the integrated light volume is lower than 2000 mJ/cm$^2$, no sufficient gas releasing quantity can be obtained and the self separation cannot be sometimes accomplished and if integrated light volume exceeds 6000 mJ/cm$^2$, the IC chip may be damaged in some cases.

It is more preferable to radiate light with the intensity of 30 to 200 mW/cm$^2$ in the integrated light volume of 2000 to 5000 mJ/cm$^2$.

In the method for producing an IC chip of the invention, a gel fraction in the pressure sensitive adhesive layer in the face contacting with the wafer is preferable to be 90% or higher at the time of 1/3 light radiation of an entire dose in the step 3. If it is lower than 90%, the hardness of the pressure sensitive adhesive layer is insufficient at the time of

starting gas generation and the force of the generated gas may be absorbed in the soft pressure sensitive adhesive layer or the pressure sensitive adhesive layer may be foamed and accordingly the self separation is hardly caused in some cases. In this description, an entire dose means the integrated light volume radiated until the time when the self separation is caused and the wafer is floated.

In the method for producing an IC chip of the invention, an elastic modulus of the pressure sensitive adhesive layer in the face contacting with the wafer is preferably $5\times10^4$ Pa or higher at the time of 1/3 light radiation of an entire dose in the step 3. If it is lower than $5\times10^4$ Pa, the hardness of the pressure sensitive adhesive layer is insufficient at the time of starting gas generation and the force of the generated gas may be absorbed in the soft pressure sensitive adhesive layer and accordingly the self separation is hardly caused in some cases.

In the method for producing an IC chip of the invention, the gas releasing speed from the pressure sensitive adhesive double-faced tape is 5 $\mu L/cm^2 \cdot min$ or higher in the step 3. If it is lower than 5 $\mu L/cm^2 \cdot min$, the pressure sensitive adhesive layer of the pressure sensitive adhesive double-faced tape cannot be completely separated from the wafer and the adhesion parts may remain like islands to makes the self separation impossible. The gas releasing speed can be achieved as described above by adjusting various conditions such as the type and content of the gas generating agent, the gel fraction and elastic modulus of the pressure sensitive adhesive layer at the time of separation, and the dose of ultraviolet rays at the time of separation.

In this description, the gas releasing speed is, as shown in Fig. 1, measured by producing an air-tight chamber in which the radiation face is sealed with glass, connecting the outlet of the chamber to a measuring pipette through a rubber tube, further connecting another outlet of measuring pipette to a funnel through a rubber tube, setting a proper amount of water, standing the measuring pipette uprightly, opening a three-way valve, adjusting the position of the funnel to adjust the water surface level at 0 point, closing the three-way valve, radiating light in normal pressure, collecting the generated gas, measuring the integrated gas generation amount for every 10 seconds, and dividing the calculated amount by the surface area of the sheet radiated with light.

The method for producing an IC chip of the invention comprises the step 4 of separating the pressure sensitive adhesive double-faced tape from the wafer. Since the pressure sensitive adhesive double-faced tape and the wafer are separated by self separation by radiating light in the step 3, even if the IC chip has a thickness as extremely thin as 50 $\mu$m or thinner, for example, about 25 to 30 $\mu$m, separation can be carried out easily without damaging the wafer.

Additionally, in normal process, before the wafer is separated by generating a gas by radiating light on completion of the grinding step, a dicing tape is stuck to the ground wafer and thereafter the wafer is separated and successively diced. However, these steps may be properly eliminated in accordance with the necessity or the order of them may be changed.

EFFECTS OF THE INVENTION

According to the invention, a method for producing an IC chip capable of producing an IC chip with a thickness as extremely thin as 50 $\mu$m or thinner, for example, about 25 to 30 $\mu$m at a high productivity can be provided.

BEST MODE FOR CARRYING OUT THE INVENTION

Hereinafter, the invention will be described more in detail with reference to Examples, however the invention should not be limited to these illustrated Examples.

(Experimental Example 1)

<Preparation of pressure sensitive adhesive>

The following compounds were dissolved in ethyl acetate and polymerized by radiating ultraviolet rays to obtain an acrylic copolymer with a weight average molecular weight of 700,000.
Next, 3.5 parts by weight of 2-isocyanatoethyl methacrylate was added to 100 parts by weight of the resin solid matter of the ethyl acetate solution containing the obtained acrylic copolymer and reaction was carried out, and on completion of the reaction, 30 parts by weight of urethane acrylate (decafunctional) (NK Oligo U 324A, manufactured by Shin-Nakamura Chemical Co., Ltd.) 0.5 parts by weight of polyisocyanate, and 0.1 parts by weight of a photopolymerization initiator (Irgacure 651) were added to and mixed with 100 parts by weight of the resin solid matter of the obtained ethyl acetate solution to prepare an ethyl acetate solution of a pressure sensitive adhesive (1).

| | |
|---|---|
| Butyl acrylate | 79 parts by weight |
| Ethyl acrylate | 15 parts by weight |

(continued)

| | |
|---|---|
| Acrylic acid | 1 part by weight |
| 2-Hydroxyethyl acrylate | 5 parts by weight |
| Photopolymerization initiator | 0.2 parts by weight (Irgacure 651, 50% ethyl acetate solution) |
| Laurylmercaptan | 0.01 parts by weight |

A pressure sensitive adhesive (2) containing a gas generating agent was prepared by mixing 10 parts by weight of 2,2'-azobis(N-butyl-2-methylpropionamide), 3.6 parts by weight of 2,4-diethylthioxanthone, 4 parts by weight of Irgacure, and 0.5 parts by weight of polyisocyanate to 100 parts by weight of the resin solid matter of the ethyl acetate solution of the pressure sensitive adhesive (1).

<Production of pressure sensitive adhesive double-faced tape>

The ethyl acetate solution of the pressure sensitive adhesive (1) was applied to one face of a 100 μm-thick transparent polyethylene terephthalate (PET) film, whose both faces were subjected to corona treatment, by a doctor knife in a proper amount to adjust the thickness of the coating in dry state to be about 30 μm and heated at 110°C for 5 minutes for drying the applied solution. Next, a PET film subjected to release treatment was stuck to the surface of the formed pressure sensitive adhesive (1) layer. After that, the resulting tape was kept still and aged at 40°C for 3 days.

The ethyl acetate solution of the pressure sensitive adhesive (2) was applied to a PET film, of which the surface was subjected to release treatment, by a doctor knife in a proper amount to adjust the thickness of the coating in dry state to be about 50 μm and heated at 110°C for 5 minutes for evaporating the solvent and drying the applied solution. The pressure sensitive adhesive layer showed the pressure sensitive adhesiveness in dry state after the drying. Next, a PET film subjected to release treatment was stuck to the surface of the formed pressure sensitive adhesive (2) layer. After that, the resulting tape was kept still and aged at 40°C for 3 days.

Successively, the face subjected to corona treatment in the side where the pressure sensitive adhesive (1) layer was not formed in the corona treated PET film having the pressure sensitive adhesive (1) layer and the face of the pressure sensitive adhesive (2) layer of the release treated PET film having the pressure sensitive adhesive (2) layer were stuck to each other. And a pressure sensitive adhesive double-faced tape having the pressure sensitive adhesive layers in both faces and protected with the PET films, of which the surfaces were respectively subjected to the release treatment, was obtained. Both of the pressure sensitive adhesive layers of the pressure sensitive adhesive double-faced tape were transparent.

<Evaluation of curability of pressure sensitive adhesive layer>

Ultraviolet rays with a wavelength of 365 nm in integrated light volume of 1600 mJ/cm$^2$ were radiated to the pressure sensitive adhesive (2) layer of the obtained pressure sensitive adhesive double-faced tape.
After radiation, the pressure sensitive adhesive (2) layer was scraped entirely from a substrate of the pressure sensitive adhesive double-faced tape by a spatula to obtain the entire amount as a sample and the weight (W1) was measured. Next, the obtained sample was immersed in ethyl acetate and shaken for 12 hours. Thereafter, the resulting sample was filtered with a metal mesh through 50 μm mesh size and heated and dried in an oven and the weight (W2) of the ethyl acetate-insoluble matter was measured. The gel fraction was calculated from W1 and W2 by the following equation.

[Eq. 1]

$$\text{Gel fraction (\%)} = \frac{W2}{W1 \times \dfrac{\text{Acrylic copolymer weight in pressure sensitive adhesive (2) layer}}{\text{weight of pressure sensitive adhesive (2) layer}}} \times 100$$

On the other hand, with respect to the pressure sensitive adhesive (2) layer after radiation, the storage modulus of shearing was measured in condition of 10 Hz frequency and 0.5% strain by a viscoelasticity measurement apparatus (DVA-200, manufactured by IT Keisoku Seigyo Co., Ltd.).

<Measurement of gas releasing speed>

The measurement apparatus shown in Fig. 1 was produced. The measurement apparatus has a structure in which a measuring pipette 3 uprightly stood is connected to an outlet of an air-tight chamber 2 whose face to be radiated is sealed with glass using a rubber tube 5 and a funnel 7 is connected to another outlet of the measuring pipette 3 using a rubber tube 6. A three-way valve 4 is attached to the rubber tube 5.
The pressure sensitive adhesive double-faced tape 1 was put in the air-tight chamber 2 in a manner that the pressure sensitive adhesive (2) layer was set upside and a proper amount of water was added through the measuring pipette 3 from the funnel 7 and the height of the water surface level was adjusted to be at 0 point of the measuring pipette 3 by adjusting the three-way valve 4 and the height of the funnel 7. After the three-way valve was closed, ultraviolet rays with a wavelength of 365 nm were radiated to the pressure sensitive adhesive double-faced tape 1 in normal pressure for 480 second in a manner that the illuminance was adjusted to be 10 $mW/cm^2$ (integrated light volume was 4800 $mJ/cm^2$). The gas generated at that time was collected and the integrated generation amount of the gas was calculated for every 10 seconds and the measurement value was divided with the surface area of the sheet radiated with light to calculate the gas releasing speed.
The similar tests were carried out using a very high pressure mercury lamp by radiating ultraviolet rays with a wavelength of 365 nm from the glass plate side while adjusting the illuminance to the glass plate surface to be 40 $mW/cm^2$ for 120 seconds (integrated light volume was 4800 $mJ/cm^2$) and also to be 100 $mW/cm^2$ for 48 seconds (integrated light volume was 4800 $mJ/cm^2$).

<Production of IC chip>

(Sticking of silicon wafer and glass plate)

After the PET film protecting the pressure sensitive adhesive (2) layer of the pressure sensitive adhesive double-faced tape was removed, the pressure sensitive adhesive (2) layer side was stuck to a silicon wafer with a thickness of about 700 μm and a diameter of 20 cm using a laminator and then the pressure sensitive adhesive double-faced tape was cut according to the size of the silicon wafer. Next, the PET film protecting the pressure sensitive adhesive (1) layer was removed and a glass plate with a diameter of 20.4 cm was stuck to the pressure sensitive adhesive (1) layer in vacuum state. The adhesion face was found having high adhesive strength immediately after adhesion.

(Grinding step)

The silicon wafer reinforced with the glass plate was set in a grinding apparatus and ground until the thickness of the silicon wafer became about 50 μm. In this case, to prevent the temperature of the silicon wafer from increase by friction heat during the grinding, the grinding work was carried out while spraying water to the silicon wafer. The silicon wafer was taken out of the grinding apparatus and a dicing tape was stuck to the silicon wafer.

(UV radiation step)

Using a very high pressure mercury lamp, ultraviolet rays with a wavelength of 365 nm were radiated from the glass plate side by adjusting the illuminance to the glass plate surface to be 10 $mW/cm^2$ for 480 seconds (integrated light volume was 4800 $mJ/cm^2$).
Further, the similar tests were carried out using a very high pressure mercury lamp, by radiating ultraviolet rays with a wavelength of 365 nm from the glass plate side by adjusting the illuminance to the glass plate surface to be 40 $mW/cm^2$ for 120 seconds (integrated light volume was 4800 $mJ/cm^2$) and also to be 100 $mW/cm^2$ for 48 seconds (integrated light volume was 4800 $mJ/cm^2$).

(Wafer separation step)

The silicon wafer was fixed and the glass plate was pulled right above and separated together with the pressure sensitive adhesive double-faced tape from the silicon wafer. In this case, if the pressure sensitive adhesive double-faced tape and the silicon wafer were separated by self separation, the case was marked with ○ and if self separation was not caused and stuck portions remained, the case was marked with ×. The results are shown in Table 1.

(Experimental Example 2)

<Preparation of pressure sensitive adhesive>

A pressure sensitive adhesive (3) containing a gas generating agent was prepared by mixing 30 parts by weight of 2,2'-azobis(N-butyl-2-methylpropionamide), 3.6 parts by weight of 2,4-diethylthioxanthone, 4 parts by weight of Irgacure, and 0.5 parts by weight of polyisocyanate with 100 parts by weight of the resin solid matter of the ethyl acetate solution of the pressure sensitive adhesive (1) prepared in Experimental Example 1.

<Production of pressure sensitive adhesive double-faced tape>

The ethyl acetate solution of the pressure sensitive adhesive (1) was applied to one face of a 100 μm-thick transparent polyethylene terephthalate (PET) film, whose both faces were subjected to corona treatment, by a doctor knife in a proper amount to adjust the thickness of the coating in dry state to be about 30 μm and heated at 110˚C for 5 minutes for drying the applied solution. Next, a PET film subjected to release treatment was stuck to the surface of the formed pressure sensitive adhesive (1) layer. After that, the resulting tape was kept still and aged at 40˚C for 3 days.

The ethyl acetate solution of the pressure sensitive adhesive (3) was applied to a PET film, of which the surface was subjected to release treatment, by a doctor knife in a proper amount to adjust the thickness of the coating in dry state to be about 50 μm and heated at 110˚C for 5 minutes for evaporating the solvent and drying the applied solution. The pressure sensitive adhesive layer showed the pressure sensitive adhesiveness in dry state after the drying. Next, a PET film subjected to release treatment was stuck to the surface of the formed pressure sensitive adhesive (3) layer. After that, the resulting tape was kept still and aged at 40˚C for 3 days.

Successively, the face subjected to corona treatment in the side where the pressure sensitive adhesive (1) layer was not formed in the corona treated PET film having the pressure sensitive adhesive (1) layer and the face of the pressure sensitive adhesive (3) layer of the release treated PET film having the pressure sensitive adhesive (3) layer were stuck to each other. And a pressure sensitive adhesive double-faced tape having the pressure sensitive adhesive layers in both faces and protected with the PET films, of which the surfaces were respectively subjected to the release treatment, was obtained. Both of the pressure sensitive adhesive layers of the pressure sensitive adhesive double-faced tape were transparent.

<Evaluation of curability of pressure sensitive adhesive layer>

Ultraviolet rays with a wavelength of 365 nm in integrated light volume of 1600 mJ/$cm^2$ were radiated to the pressure sensitive adhesive (3) layer of the obtained pressure sensitive adhesive double-faced tape. After radiation, the gel fraction and the elastic modulus of the pressure sensitive adhesive (3) layer were measured in the same manners as those of Experimental Example 1.

<Measurement of gas releasing speed>

Using the same apparatus used in Experimental Example 1, ultraviolet rays with a wavelength of 365 nm were radiated to the obtained pressure sensitive adhesive double-faced tape in a manner that the illuminance was adjusted to be 10 mW/$cm^2$ in the surface for 480 seconds (integrated light volume was 4800 mJ/$cm^2$). The gas generated at that time was collected and the integrated generation amount of the gas was calculated for every 10 seconds and the measurement value was divided with the surface area of the sheet radiated with light to calculate the gas releasing speed. The similar tests were carried out using a very high pressure mercury lamp by radiating ultraviolet rays with a wavelength of 365 nm from the glass plate side while adjusting the illuminance to the glass plate surface to be 40 mW/$cm^2$ for 120 seconds (integrated light volume was 4800 mJ/$cm^2$) and also to be 100 mM/$cm^2$ for 48 seconds (integrated light volume was 4800 mJ/$cm^2$).

<Production of IC chip>

(Sticking of silicon wafer and glass plate)

After the PET film protecting the pressure sensitive adhesive (3) layer of the pressure sensitive adhesive double-faced tape was removed, the pressure sensitive adhesive (3) layer side was stuck to a silicon wafer with a thickness of about 700 μm and a diameter of 20 cm using a laminator and then the pressure sensitive adhesive double-faced tape was cut according to the size of the silicon wafer. Next, the PET film protecting the pressure sensitive adhesive (1) layer was removed and a glass plate with a diameter of 20.4 cm was stuck to the pressure sensitive adhesive (1)

layer in vacuum state. The adhesion face was found having high adhesive strength immediately after adhesion.

(Grinding step)

The silicon wafer reinforced with the glass plate was set in a grinding apparatus and ground until the thickness of the silicon wafer became about 50 μm. In this case, to prevent the temperature of the silicon wafer from increase by friction heat during the grinding, the grinding work was carried out while spraying water to the silicon wafer. The silicon wafer was taken out of the grinding apparatus and a dicing tape was stuck to the silicon wafer.

(UV radiation step)

Using a very high pressure mercury lamp, ultraviolet rays with a wavelength of 365 nm were radiated from the glass plate side by adjusting the illuminance to the glass plate surface to be 10 mW/cm$^2$ for 480 seconds (integrated light volume was 4800 mJ/cm$^2$).
Further, the similar tests were carried out using a very high pressure mercury lamp by radiating ultraviolet rays with a wavelength of 365 nm from the glass plate side by adjusting the illuminance to the glass plate surface to be 40 mW/cm$^2$ for 120 seconds (integrated light volume was 4800 mJ/cm$^2$) and also to be 100 mW/cm$^2$ for 48 seconds (integrated light volume was 4800 mJ/cm$^2$).

(Wafer separation step)

The silicon wafer was fixed and the glass plate was pulled right above and separated together with the pressure sensitive adhesive double-faced tape from the silicon wafer. In this case, if the pressure sensitive adhesive double-faced tape and the silicon wafer were separated by self separation, the case was marked with ○ and if self separation was not caused and stuck portions remained, the case was marked with ×. The results are shown in Table 1.

(Experimental Example 3)

<Preparation of pressure sensitive adhesive>

A pressure sensitive adhesive (4) containing a gas generating agent was prepared by mixing 50 parts by weight of 2,2'-azobis(N-butyl-2-methylpropionamide), 3.6 parts by weight of 2,4-diethylthioxanthone, 4 parts by weight of Irgacure, and 0.5 parts by weight of polyisocyanate with 100 parts by weight of the resin solid matter of the ethyl acetate solution of the pressure sensitive adhesive (1) prepared in Experimental Example 1.

<Production of pressure sensitive adhesive double-faced tape>

The ethyl acetate solution of the pressure sensitive adhesive (1) was applied to one face of a 100 μm-thick transparent polyethylene terephthalate (PET) film, whose both faces were subjected to corona treatment, by a doctor knife in a proper amount to adjust the thickness of the coating in dry state to be about 30 μm and heated at 110˚C for 5 minutes for drying the applied solution. Next, a PET film subjected to release treatment was stuck to the surface of the formed pressure sensitive adhesive (1) layer. After that, the resulting tape was kept still and aged at 40˚C for 3 days.
The ethyl acetate solution of the pressure sensitive adhesive (4) was applied to a PET film, of which the surface was subjected to release treatment, by a doctor knife in a proper amount to adjust the thickness of the coating in dry state to be about 50 μm and heated at 110˚C for 5 minutes for evaporating the solvent and drying the applied solution. The pressure sensitive adhesive layer showed the pressure sensitive adhesiveness in dry state after the drying. Next, a PET film subjected to release treatment was stuck to the surface of the formed pressure sensitive adhesive (4) layer. After that, the resulting tape was kept still and aged at 40˚C for 3 days.
Successively, the face subjected to corona treatment in the side where the pressure sensitive adhesive (1) layer was not formed in the corona treated PET film having the pressure sensitive adhesive (1) layer and the face of the pressure sensitive adhesive (4) layer of the release treated PET film having the pressure sensitive adhesive (4) layer were stuck to each other. And a pressure sensitive adhesive double-faced tape having the pressure sensitive adhesive layers in both faces and protected with the PET films, of which the surfaces were respectively subjected to the release treatment, was obtained. Both of the pressure sensitive adhesive layers of the pressure sensitive adhesive double-faced tape were transparent.

<Evaluation of curability of pressure sensitive adhesive layer>

Ultraviolet rays with a wavelength of 365 nm in integrated light volume of 1600 mJ/cm$^2$ were radiated to the pressure sensitive adhesive (4) layer of the obtained pressure sensitive adhesive double-faced tape. After radiation, the gel fraction and the elastic modulus of the pressure sensitive adhesive (4) layer were measured in the same manners as those of Experimental Example 1.

<Measurement of gas releasing speed>

Using the same apparatus used in Experimental Example 1, ultraviolet rays with a wavelength of 365 nm were radiated to the obtained pressure sensitive adhesive double-faced tape in a manner that the illuminance was adjusted to be 10 mW/cm$^2$ in the surface for 480 seconds (integrated light volume was 4800 mJ/cm$^2$). The gas generated at that time was collected and the integrated generation amount of the gas was calculated for every 10 seconds and the measurement value was divided with the surface area of the sheet radiated with light to calculate the gas releasing speed. The similar tests were carried out using a very high pressure mercury lamp by radiating ultraviolet rays with a wavelength of 365 nm from the glass plate side while adjusting the illuminance to the glass plate surface to be 40 mW/cm$^2$ for 120 seconds (integrated light volume was 4800 mJ/cm$^2$) and also to be 100 mW/cm$^2$ for 48 seconds (integrated light volume was 4800 mJ/cm$^2$).

<Production of IC chip>

(Sticking of silicon wafer and glass plate)

After the PET film protecting the pressure sensitive adhesive (4) layer of the pressure sensitive adhesive double-faced tape was removed, the pressure sensitive adhesive (4) layer side was stuck to a silicon wafer with a thickness of about 700 μm and a diameter of 20 cm using a laminator and then the pressure sensitive adhesive double-faced tape was cut according to the size of the silicon wafer. Next, the PET film protecting the pressure sensitive adhesive (1) layer was removed and a glass plate with a diameter of 20.4 cm was stuck to the pressure sensitive adhesive (1) layer in vacuum state. The adhesion face was found having high adhesive strength immediately after adhesion.

(Grinding step)

The silicon wafer reinforced with the glass plate was set in a grinding apparatus and ground until the thickness of the silicon wafer became about 50 μm. In this case, to prevent the temperature of the silicon wafer from increase by friction heat during the grinding, the grinding work was carried out while spraying water to the silicon wafer. The silicon wafer was taken out of the grinding apparatus and a dicing tape was stuck to the silicon wafer.

(UV radiation step)

Using a very high pressure mercury lamp, ultraviolet rays with a wavelength of 365 nm were radiated from the glass plate side by adjusting the illuminance to the glass plate surface to be 10 mW/cm$^2$ for 480 seconds (integrated light volume was 4800 mJ/cm$^2$).
Further, the similar tests were carried out using a very high pressure mercury lamp, by radiating ultraviolet rays with a wavelength of 365 nm from the glass plate side by adjusting the illuminance to the glass plate surface to be 40 mW/cm$^2$ for 120 seconds (integrated light volume was 4800 mJ/cm$^2$) and also to be 100 mW/cm$^2$ for 48 seconds (integrated light volume was 4800 mJ/cm$^2$).

(Wafer separation step)

The silicon wafer was fixed and the glass plate was pulled right above and separated together with the pressure sensitive adhesive double-faced tape from the silicon wafer. In this case, if the pressure sensitive adhesive double-faced tape and the silicon wafer were separated by self separation, the case was marked with ○ and if self separation was not caused and stuck portions remained, the case was marked with ×. The results are shown in Table 1.

(Experimental Example 4)

<Preparation of pressure sensitive adhesive>

The following compounds were dissolved in ethyl acetate and polymerized by radiating ultraviolet rays to obtain an acrylic copolymer with a weight average molecular weight of 700,000.
Next, 3.5 parts by weight of 2-isocyanatoethyl methacrylate was added to 100 parts by weight of the resin solid matter of the ethyl acetate solution containing the obtained acrylic copolymer and reaction was carried out, and on completion of the reaction, 0.5 parts by weight of polyisocyanate and 0.1 parts by weight of a photopolymerization initiator (Irgacure 651) were added to and mixed with 100 parts by weight of the resin solid matter of the obtained ethyl acetate solution to prepare an ethyl acetate solution of a pressure sensitive adhesive (1').

| | |
|---|---|
| Butyl acrylate | 79 parts by weight |
| Ethyl acrylate | 15 parts by weight |
| Acrylic acid | 1 part by weight |
| 2-Hydroxyethyl acrylate | 5 parts by weight |
| Photopolymerization initiator | 0.2 parts by weight (Irgacure 651, 50% ethyl acetate solution) |
| Laurylmercaptan | 0.01 parts by weight |

A pressure sensitive adhesive (3') containing a gas generating agent was prepared by mixing 30 parts by weight of 2,2'-azobis(N-butyl-2-methylpropionamide), 3.6 parts by weight of 2,4-diethylthioxanthone, 4 parts by weight of Irgacure, and 0.5 parts by weight of polyisocyanate to 100 parts by weight of the resin solid matter of the ethyl acetate solution of the pressure sensitive adhesive (1').

<Production of pressure sensitive adhesive double-faced tape>

The ethyl acetate solution of the pressure sensitive adhesive (1') was applied to one face of a 100 μm-thick transparent polyethylene terephthalate (PET) film, whose both faces were subjected to corona treatment, by a doctor knife in a proper amount to adjust the thickness of the coating in dry state to be about 30 μm and heated at 110˚C for 5 minutes for drying the applied solution. Next, a PET film subjected to release treatment was stuck to the surface of the formed pressure sensitive adhesive (1') layer. After that, the resulting tape was kept still and aged at 40˚C for 3 days.

The ethyl acetate solution of the pressure sensitive adhesive (3') was applied to a PET film, of which the surface was subjected to release treatment, by a doctor knife in a proper amount to adjust the thickness of the coating in dry state to be about 50 μm and heated at 110˚C for 5 minutes for evaporating the solvent and drying the applied solution. The pressure sensitive adhesive layer showed the pressure sensitive adhesiveness in dry state after the drying. Next, a PET film subjected to release treatment was stuck to the surface of the formed pressure sensitive adhesive (3') layer. After that, the resulting tape was kept still and aged at 40˚C for 3 days.

Successively, the face subjected to corona treatment in the side where the pressure sensitive adhesive (1') layer was not formed in the corona treated PET film having the pressure sensitive adhesive (1') layer and the face of the pressure sensitive adhesive (3') layer of the release treated PET film having the pressure sensitive adhesive (3') layer were stuck to each other. And a pressure sensitive adhesive double-faced tape having the pressure sensitive adhesive layers in both faces and protected with the PET films, of which the surfaces were respectively subjected to the release treatment, was obtained. Both of the pressure sensitive adhesive layers of the pressure sensitive adhesive double-faced tape were transparent.

<Evaluation of curability of pressure sensitive adhesive layer>

Ultraviolet rays with a wavelength of 365 nm in integrated light volume of 1600 $mJ/cm^2$ were radiated to the pressure sensitive adhesive (3') layer of the obtained pressure sensitive adhesive double-faced tape. After radiation, the gel fraction and the elastic modulus of the pressure sensitive adhesive (3') layer were measured in the same manners as those of Experimental Example 1.

<Measurement of gas releasing speed>

Using the same apparatus used in Experimental Example 1, ultraviolet rays with a wavelength of 365 nm were radiated to the obtained pressure sensitive adhesive double-faced tape in a manner that the illuminance was adjusted to be 40 $mW/cm^2$ in the surface for 120 seconds (integrated light volume was 4800 $mJ/cm^2$). The gas generated at that

time was collected and the integrated generation amount of the gas was calculated for every 10 seconds and the measurement value was divided with the surface area of the sheet radiated with light to calculate the gas releasing speed.

<Production of IC chip>

(Sticking of silicon wafer and glass plate)

After the PET film protecting the pressure sensitive adhesive (3') layer of the pressure sensitive adhesive double-faced tape was removed, the pressure sensitive adhesive (3') layer side was stuck to a silicon wafer with a thickness of about 700 μm and a diameter of 20 cm using a laminator and then the pressure sensitive adhesive double-faced tape was cut according to the size of the silicon wafer. Next, the PET film protecting the pressure sensitive adhesive (1') layer was removed and a glass plate with a diameter of 20.4 cm was stuck to the pressure sensitive adhesive (1') layer in vacuum state. The adhesion face was found having high adhesive strength immediately after adhesion.

(Grinding step)

The silicon wafer reinforced with the glass plate was set in a grinding apparatus and ground until the thickness of the silicon wafer became about 50 μm. In this case, to prevent the temperature of the silicon wafer from increase by friction heat during the grinding, the grinding work was carried out while spraying water to the silicon wafer. The silicon wafer was taken out of the grinding apparatus and a dicing tape was stuck to the silicon wafer.

(UV radiation step)

Using a very high pressure mercury lamp, ultraviolet rays with a wavelength of 365 nm were radiated from the glass plate side by adjusting the illuminance to the glass plate surface to be 40 $mW/cm^2$ for 120 seconds (integrated light volume was 4800 $mJ/cm^2$).

(Wafer separation step)

The silicon wafer was fixed and the glass plate was pulled right above and separated together with the pressure sensitive adhesive double-faced tape from the silicon wafer. In this case, if the pressure sensitive adhesive double-faced tape and the silicon wafer were separated by self separation, the case was marked with ○ and if self separation was not caused and stuck portions remained, the case was marked with ×. The results are shown in Table 1.

(Experimental Example 5)

<Preparation of pressure sensitive adhesive>

A pressure sensitive adhesive (5-1) containing a gas generating agent was prepared by mixing 5 parts by weight of 1,1'-(azodicarbonyl)dipiperidine, 3.6 parts by weight of 2,4-diethylthioxanthone, 4 parts by weight of Irgacure, and 0.5 parts by weight of polyisocyanate with 100 parts by weight of the resin solid matter of the ethyl acetate solution of the pressure sensitive adhesive (1) prepared in Experimental Example 1. Further, a pressure sensitive adhesive (5-2) was prepared in the same manner, except that the addition amount of 1,1'-(azodicarbonyl)dipiperidine was changed to 10 parts by weight and a pressure sensitive adhesive (5-3) was prepared in the same manner, except that the addition amount of 1,1'-(azodicarbonyl)dipiperidine was changed to 30 parts by weight.

<Production of pressure sensitive adhesive double-faced tape>

The ethyl acetate solution of the pressure sensitive adhesive (1) was applied to one face of a 100 μm-thick transparent polyethylene terephthalate (PET) film, whose both faces were subjected to corona treatment, by a doctor knife in a proper amount to adjust the thickness of the coating in dry state to be about 30 μm and heated at 110°C for 5 minutes for drying the applied solution. Next, a PET film subjected to release treatment was stuck to the surface of the formed pressure sensitive adhesive (1) layer. After that, the resulting tape was kept still and aged at 40°C for 3 days.

The ethyl acetate solution of the pressure sensitive adhesive (5-1) was applied to a PET film, of which the surface was subjected to release treatment, by a doctor knife in a proper amount to adjust the thickness in dry state to be about 50 μm and heated at 110°C for 5 minutes for evaporating the solvent and drying the applied solution. The pressure sensitive adhesive layer showed the pressure sensitive adhesiveness in dry state after the drying. Next, a PET film subjected to release treatment was stuck to the surface of the formed pressure sensitive adhesive (5-1) layer. After

that, the resulting tape was kept still and aged at 40˚C for 3 days. In the same manner, PET films respectively coated with a pressure sensitive adhesive (5-2) layer and a pressure sensitive adhesive (5-3) layer were produced.

Successively, the face subjected to corona treatment in the side where the pressure sensitive adhesive (1) layer was not formed in the corona treated PET film having the pressure sensitive adhesive (1) layer and the face of the pressure sensitive adhesive (5-1) layer of the release treated PET film having the pressure sensitive adhesive (5-1) layer were stuck to each other. And a pressure sensitive adhesive double-faced tape having the pressure sensitive adhesive layers in both faces and protected with the PET films, of which the surfaces were respectively subjected to the release treatment, was obtained. Both of the pressure sensitive adhesive layers of the pressure sensitive adhesive double-faced tape were transparent. Using the PET films respectively coated with the pressure sensitive adhesive (5-2) layer and the pressure sensitive adhesive (5-3) layer, pressure sensitive adhesive double-faced tapes were obtained in the same manner.

Accordingly, three kinds in total of the pressure sensitive adhesive double-faced tapes were obtained. Hereinafter these three kinds of pressure sensitive adhesive double-faced tapes were evaluated. In this connection, the pressure sensitive adhesive (5) means the pressure sensitive adhesive (5-1) layer, the pressure sensitive adhesive (5-2) layer, and the pressure sensitive adhesive (5-3) layer, unless otherwise specified.

<Evaluation of curability of pressure sensitive adhesive layer>

Ultraviolet rays with a wavelength of 365 nm in integrated light volume of 1600 mJ/cm$^2$ were radiated to the pressure sensitive adhesive (5) layers of the obtained pressure sensitive adhesive double-faced tapes. After radiation, the gel fractions and the elastic modulus of the pressure sensitive adhesive (5) layers were measured in the same manners as those of Experimental Example 1.

<Measurement of gas releasing speed>

Using the same apparatus used in Experimental Example 1, ultraviolet rays with a wavelength of 365 nm were radiated to the obtained pressure sensitive adhesive double-faced tape in a manner that the illuminance was adjusted to be 200 mW/cm$^2$ in the surface for 24 seconds (integrated light volume was 4800 mJ/cm$^2$). The gas generated at that time was collected and the integrated generation amount of the gas was calculated for every 10 seconds and the measurement value was divided with the surface area of the sheet radiated with light to calculate the gas releasing speed.

<Production of IC chip>

(Sticking of silicon wafer and glass plate)

After the PET film protecting the pressure sensitive adhesive (5) layer of the pressure sensitive adhesive double-faced tape was removed, the pressure sensitive adhesive (5) layer side was stuck to a silicon wafer with a thickness of about 700 μm and a diameter of 20 cm using a laminator and then the pressure sensitive adhesive double-faced tape was cut according to the size of the silicon wafer. Next, the PET film protecting the pressure sensitive adhesive (1) layer was removed and a glass plate with a diameter of 20.4 cm was stuck to the pressure sensitive adhesive (1) layer in vacuum state. The adhesion face was found having high adhesive strength immediately after adhesion.

(Grinding step)

The silicon wafer reinforced with the glass plate was set in a grinding apparatus and ground until the thickness of the silicon wafer became about 50 μm. In this case, to prevent the temperature of the silicon wafer from increase by friction heat during the grinding, the grinding work was carried out while spraying water to the silicon wafer. The silicon wafer was taken out of the grinding apparatus and a dicing tape was stuck to the silicon wafer.

(UV radiation step)

Using a very high pressure mercury lamp, ultraviolet rays with a wavelength of 365 nm were radiated from the glass plate side by adjusting the illuminance to the glass plate surface to be 200 mW/cm$^2$ for 24 seconds (integrated light volume was 4800 mJ/cm$^2$).

(Wafer separation step)

The silicon wafer was fixed and the glass plate was pulled right above and separated together with the pressure

sensitive adhesive double-faced tape from the silicon wafer. In this case, if the pressure sensitive adhesive double-faced tape and the silicon wafer were separated by self separation, the case was marked with ○ and if self separation was not caused and stuck portions remained, the case was marked with ×. The results are shown in Table 1.

(Experimental Example 6)

<Preparation of pressure sensitive adhesive>

A pressure sensitive adhesive (6-1) containing a gas generating agent was prepared by mixing 1 part by weight of glycidylazido polymer, 3.6 parts by weight of 2,4-diethylthioxanthone, 4 parts by weight of Irgacure, and 0.5 parts by weight of polyisocyanate with 100 parts by weight of the resin solid matter of the ethyl acetate solution of the pressure sensitive adhesive (1) prepared in Experimental Example 1. Further, a pressure sensitive adhesive (6-2) was prepared in the same manner, except that the addition amount of glycidylazido polymer was changed to 3 parts by weight and a pressure sensitive adhesive (6-3) was prepared in the same manner, except that the addition amount of glycidylazido polymer was changed to 5 parts by weight.

<Production of pressure sensitive adhesive double-faced tape>

The ethyl acetate solution of the pressure sensitive adhesive (1) was applied to one face of a 100 μm-thick transparent polyethylene terephthalate (PET) film, whose both faces were subjected to corona treatment, by a doctor knife in a proper amount to adjust the thickness of the coating in dry state to be about 30 μm and heated at 110˚C for 5 minutes for drying the applied solution. Next, a PET film subjected to release treatment was stuck to the surface of the formed pressure sensitive adhesive (1) layer. After that, the resulting tape was kept still and aged at 40˚C for 3 days.
The ethyl acetate solution of the pressure sensitive adhesive (5-1) was applied to a PET film, of which the surface was subjected to release treatment, by a doctor knife in a proper amount to adjust the thickness of the coating in dry state to be about 50 μm and heated at 110˚C for 5 minutes for evaporating the solvent and drying the applied solution. The pressure sensitive adhesive layer showed the pressure sensitive adhesiveness in dry state after the drying. Next, a PET film subjected to release treatment was stuck to the surface of the formed pressure sensitive adhesive (6-1) layer. After that, the resulting tape was kept still and aged at 40˚C for 3 days. In the same manner, PET films respectively coated with a pressure sensitive adhesive (6-2) layer and a pressure sensitive adhesive (6-3) layer were produced.
Successively, the face subjected to corona treatment in the side where the pressure sensitive adhesive (1) layer was not formed in the corona treated PET film having the pressure sensitive adhesive (1) layer and the face of the pressure sensitive adhesive (6-1) layer of the release treated PET film having the pressure sensitive adhesive (6-1) layer were stuck to each other. And a pressure sensitive adhesive double-faced tape having the pressure sensitive adhesive layers in both faces and protected with the PET films, of which the surfaces were respectively subjected to the release treatment, was obtained. Both of the pressure sensitive adhesive layers of the pressure sensitive adhesive double-faced tape were transparent. Using the PET films respectively coated with the pressure sensitive adhesive (6-2) layer and the pressure sensitive adhesive (6-3) layer, pressure sensitive adhesive double-faced tapes were obtained in the same manner.
Accordingly, three kinds in total of the pressure sensitive adhesive double-faced tapes were obtained. Hereinafter these three kinds of pressure sensitive adhesive double-faced tapes were evaluated. In this connection, the pressure sensitive adhesive (6) means the pressure sensitive adhesive (6-1) layer, the pressure sensitive adhesive (6-2) layer, and the pressure sensitive adhesive (6-3) layer, unless otherwise specified.

<Evaluation of curability of pressure sensitive adhesive layer>

Ultraviolet rays with a wavelength of 365 nm in integrated light volume of 1600 $mJ/cm^2$ were radiated to the pressure sensitive adhesive (6) layers of the obtained pressure sensitive adhesive double-faced tapes. After radiation, the gel fractions and the elastic modulus of the pressure sensitive adhesive (6) layers were measured in the same manners as those of Experimental Example 1.

<Measurement of gas releasing speed>

Using the same apparatus used in Experimental Example 1, ultraviolet rays with a wavelength of 365 nm were radiated to the obtained pressure sensitive adhesive double-faced tape in a manner that the illuminance was adjusted to be 40 $mW/cm^2$ in the surface for 120 seconds (integrated light volume was 4800 $mJ/cm^2$). The gas generated at that time was collected and the integrated generation amount of the gas was calculated for every 10 seconds and the measurement value was divided with the surface area of the sheet radiated with light to calculate the gas releasing speed.

<Production of IC chip>

(Sticking of silicon wafer and glass plate)

After the PET film protecting the pressure sensitive adhesive (6) layer of the pressure sensitive adhesive double-faced tape was removed, the pressure sensitive adhesive (6) layer side was stuck to a silicon wafer with a thickness of about 700 μm and a diameter of 20 cm using a laminator and then the pressure sensitive adhesive double-faced tape was cut according to the size of the silicon wafer. Next, the PET film protecting the pressure sensitive adhesive (1) layer was removed and a glass plate with a diameter of 20.4 cm was stuck to the pressure sensitive adhesive (1) layer in vacuum state. The adhesion face was found having high adhesive strength immediately after adhesion.

(Grinding step)

The silicon wafer reinforced with the glass plate was set in a grinding apparatus and ground until the thickness of the silicon wafer became about 50 μm. In this case, to prevent the temperature of the silicon wafer from increase by friction heat during the grinding, the grinding work was carried out while spraying water to the silicon wafer. The silicon wafer was taken out of the grinding apparatus and a dicing tape was stuck to the silicon wafer.

(UV radiation step)

Using a very high pressure mercury lamp, ultraviolet rays with a wavelength of 365 nm were radiated from the glass plate side by adjusting the illuminance to the glass plate surface to be 40 $mW/cm^2$ for 120 seconds (integrated light volume was 4800 $mJ/cm^2$).

(Wafer separation step)

The silicon wafer was fixed and the glass plate was pulled right above and separated together with the pressure sensitive adhesive double-faced tape from the silicon wafer. In this case, if the pressure sensitive adhesive double-faced tape and the silicon wafer were separated by self separation, the case was marked with ○ and if self separation was not caused and stuck portions remained, the case was marked with ×. The results are shown in Table 1.

[Table 1]

| | Gas generating agent | | Pressure sensitive adhesive | | | | Production of IC chip | | | |
|---|---|---|---|---|---|---|---|---|---|---|
| | type | content (part by weight) | type of polyfunctional monomer | content of polyfunctional monomer (part by weight) | gel fraction at the time of 1/3 radiation (%) | elastic modulus at the time of 1/3 radiation (Pa) | illuminance of ultraviolet rays ($mW/cm^2$) | dose of ultraviolet rays ($mJ/cm^2$) | gas releasing speed ($\mu L/cm^2 \cdot min$) | self separation |
| Experimental Example1 | 2,2'-azobis (N-butyl-2-methylpropionamide) | 10 | urethane acrylate (decafunctional) | 30 | 99.0 | $1 \times 10^8$ | 10 | 4800 | 1 | × |
| | | | | | | | 40 | | 4 | × |
| | | | | | | | 100 | | 10 | ○ |
| Experimental Example2 | | 30 | | | 99.0 | $5 \times 10^7$ | 10 | | 2 | × |
| | | | | | | | 40 | | 11 | ○ |
| | | | | | | | 100 | | 25 | ○ |
| Experimental Example3 | | 50 | | | 99.0 | $8 \times 10^6$ | 10 | | 6 | ○ |
| | | | | | | | 40 | | 24 | ○ |
| | | | | | | | 100 | | 60 | ○ |
| Experimental Example4 | | 30 | - | - | 80.0 | $1 \times 10^5$ | 40 | | 4 | × |
| Experimental Example5 | 1,1'-(azodicarbonyl) dipiperidine | 5 | urethane acrylate (decafunctional) | 30 | 99.0 | $5 \times 10^8$ | 200 | | 3 | × |
| | | 10 | | | 99.0 | $1 \times 10^8$ | | | 6 | ○ |
| | | 30 | | | 99.0 | $5 \times 10^7$ | | | 10 | ○ |
| Experimental Example6 | glycidylazido polymer | 1 | | | 99.0 | $8 \times 10^7$ | 40 | | 4 | × |
| | | 3 | | | 99.0 | $2 \times 10^7$ | | | 10 | ○ |
| | | 5 | | | 99.0 | $8 \times 10^6$ | | | 15 | ○ |

INDUSTRIAL APPLICABILITY OF THE INVENTION

According to the invention, a method for producing an IC chip capable of producing an IC chip with a thickness as extremely thin as 50 μm or thinner, for example, about 25 to 30 μm at a high productivity can be provided.

BRIEF DESCRIPTION OF DRAWINGS

Fig. 1 is an illustration showing an apparatus for measuring the gas releasing speed.

EXPLANATION OF REFERENCE

1 pressure sensitive adhesive double-faced tape
2 air-tight chamber
3 measuring pipette
4 three-way valve
5 rubber tube
6 rubber tube
7 funnel

## Claims

1. A method for producing an IC chip, which comprises; at least
a step 1 of fixing a wafer in a support plate by sticking the wafer to the gas generating agent-containing face of a pressure sensitive adhesive double-faced tape having a pressure sensitive adhesive layer containing a gas generating agent for generating a gas by light radiation in at least one face;
a step 2 of grinding the wafer in a state of being fixed in the support plate through the pressure sensitive adhesive double-faced tape;
a step 3 of radiating light to the pressure sensitive adhesive double-faced tape; and
a step 4 of separating the pressure sensitive adhesive double-faced tape from the wafer,
a gas releasing speed from the pressure sensitive adhesive double-faced tape being 5 L/cm$^2$·min or higher in the step 3.

2. The method for producing an IC chip according to claim 1, wherein the gas generating agent is an azoamide compound represented by the following general formula (1):

[Chem. 1]

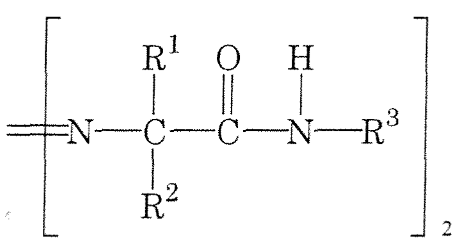

(1)

in the formula (1), $R^1$ and $R^2$ independently represent a lower alkyl group; $R^3$ represents a saturated alkyl group having 2 or more carbon atoms; and $R^1$ and $R^2$ may be same or different.

3. The method for producing an IC chip according to claim 2, wherein the content of the gas generating agent in the gas generating agent-containing pressure sensitive adhesive

layer is 5 to 50 parts by weight to 100 parts by weight of the pressure sensitive adhesive.

**4.** The method for producing an IC chip according to claim 1, wherein the pressure sensitive adhesive containing the gas generating agent is a stimulation-curing pressure sensitive adhesive having pressure sensitive adhesive strength decreased by stimulation.

**5.** The method for producing an IC chip according to claim 4, wherein the stimulation-curing pressure sensitive adhesive contains an acrylic acid alkyl ester and/or methacrylic acid alkyl ester polymerizable polymer having a radical polymerizable unsaturated bond in a molecule, and a radical polymerizable polyfunctional oligomer or polyfunctional monomer, as main components.

**6.** The method for producing an IC chip according to claim 5, wherein the number of a functional group per one molecule of the polyfunctional oligomer or polyfunctional monomer is 5 or higher.

**7.** The method for producing an IC chip according to claim 5 or 6, wherein the stimulation-curing pressure sensitive adhesive contains 10 to 100 parts by weight of the polyfunctional oligomer or polyfunctional monomer to 100 parts by weight of the acrylic acid alkyl ester and/or methacrylic acid alkyl ester polymerizable polymer having a radical polymerizable unsaturated bond in a molecule.

**8.** The method for producing an IC chip according to claim 4, wherein a gel fraction of the pressure sensitive adhesive layer in the face contacting with the wafer is 90% or higher at the time of 1/3 light radiation of an entire dose in the step 3.

**9.** The method for producing an IC chip according to claim 4, wherein an elastic modulus of the pressure sensitive adhesive layer in the face contacting with the wafer is $5 \times 10^4$ Pa or higher at the time of 1/3 light radiation of an entire dose in the step 3.

**10.** The method for producing an IC chip according to claim 1, wherein light radiation is carried out at light intensity of 20 to 500 $mW/cm^2$ in integrated light volume of 2000 to 6000 $mJ/cm^2$ in the step 3.

[Fig. 1]

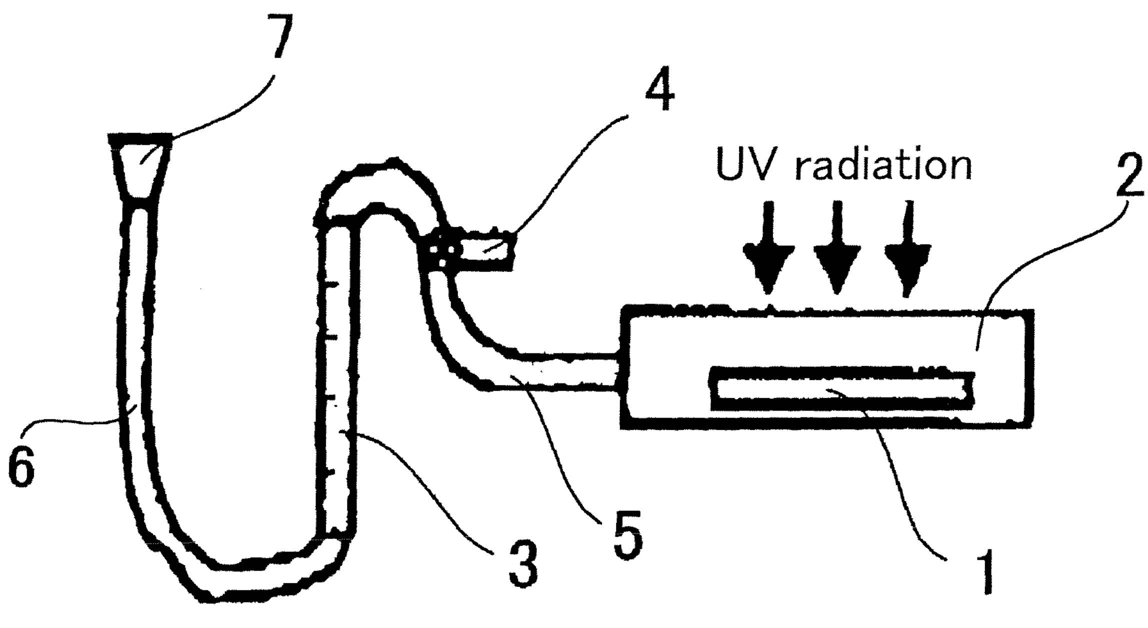

**INTERNATIONAL SEARCH REPORT**

International application No.
PCT/JP2004/011057

A. CLASSIFICATION OF SUBJECT MATTER
Int.Cl$^7$ H01L21/02, H01L21/68, C09J201/00, C09J5/00, C09J7/02

According to International Patent Classification (IPC) or to both national classification and IPC

B. FIELDS SEARCHED

Minimum documentation searched (classification system followed by classification symbols)
Int.Cl$^7$ H01L21/02, H01L21/68, C09J201/00, C09J5/00, C09J7/02

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2004 |
| Kokai Jitsuyo Shinan Koho | 1971-2004 | Toroku Jitsuyo Shinan Koho | 1994-2004 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2003-171645 A (Sekisui Chemical Co., Ltd.), 20 June, 2003 (20.06.03), Full text & WO 2003/48265 A1 | 1-10 |
| X | JP 2003-231875 A (Sekisui Chemical Co., Ltd.), 19 August, 2003 (19.08.03), Full text & WO 2003/42319 A1 & JP 2003-231867 A | 1-10 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 19 November, 2004 (19.11.04) | 07 December, 2004 (07.12.04) |

| Name and mailing address of the ISA/ | Authorized officer |
|---|---|
| Japanese Patent Office | |
| Facsimile No. | Telephone No. |

Form PCT/ISA/210 (second sheet) (January 2004)

## INTERNATIONAL SEARCH REPORT

International application No.
PCT/JP2004/011057

C (Continuation). DOCUMENTS CONSIDERED TO BE RELEVANT

| Category* | Citation of document, with indication, where appropriate, of the relevant passages | Relevant to claim No. |
|---|---|---|
| A | JP 9-291070 A (Wako Pure Chemical Industries, Ltd.), 11 November, 1997 (11.11.97), Full text & EP 792869 A1 Full text & US 5849888 A1 | 1-10 |

Form PCT/ISA/210 (continuation of second sheet) (January 2004)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2003231872 A